(19) **Europäisches Patentamt**

**European Patent Office**

**Office européen des brevets**

(11) **EP 1 315 194 A2**

(12) **EUROPEAN PATENT APPLICATION**

(43) Date of publication:
28.05.2003 Bulletin 2003/22

(51) Int Cl.7: **H01J 37/32**, C23C 16/44

(21) Application number: **02258147.4**

(22) Date of filing: **27.11.2002**

(84) Designated Contracting States:
**AT BE BG CH CY CZ DE DK EE ES FI FR GB GR
IE IT LI LU MC NL PT SE SK TR**
Designated Extension States:
**AL LT LV MK RO SI**

(30) Priority: **27.11.2001 JP 2001361669**

(71) Applicant: **ASM JAPAN K.K.**
**Tama-shi, Tokyo 206-0025 (JP)**

(72) Inventor: **Fukuda, Hideaki**
**Tokyo 206-0025 (JP)**

(74) Representative: **Mallalieu, Catherine Louise et al**
**D. Young & Co.,**
**21 New Fetter Lane**
**London EC4A 1DA (GB)**

(54) **Plasma CVD apparatus and method with self-cleaning capability**

(57)    A plasma CVD apparatus conducting self-cleaning comprises a reaction chamber, a susceptor, a showerhead, a temperature controlling mechanism for directly controlling the temperature of the showerhead at a temperature of 200°C to 400°C, a remote plasma discharge device provided outside the reaction chamber, and a radio-frequency power source electrically connected to either of the susceptor or the showerhead.

**FIG. 2**

**Description**

Background of the Invention

Field of the Invention

The present invention relates to a plasma CVD (chemical vapor deposition) apparatus comprising a self-cleaning device. The present invention particularly relates to a plasma CVD apparatus which cleans the inside of a reaction chamber using active species generated remotely.

Description of the Related Art

Generally, a plasma treatment apparatus is used for forming or removing films or for reforming the surface of an object-to-be-processed. In particular, thin film formation (by plasma CVD) on semiconductor wafers such as silicon or glass substrates or thin film etching is essential technique for manufacturing memories, semiconductor devices such as CPU's, or LCD's (Liquid Crystal Displays).

Conventionally, the CVD apparatus has been used for forming silicon substrates or glass substrates provided with insulation films such as those of silicon oxide (SiO), silicon nitride (SiN), silicon carbide (SiC), and silicon oxide carbide (SiOC), conductor films such as those of tungsten silicide (WSi), titanium nitride (TiN), and aluminum (Al) alloy, and high-dielectric films such as those of PZT($PbZr_{1-x}Ti_xO_3$) and BST ($Ba_xSr_{1-x}TiO_3$).

To form these films, multiple reaction gases having various constituents are brought into a reaction chamber. In the plasma CVD apparatus, these reaction gases are excited into a plasma by radio-frequency energy and form a desired thin film by causing a chemical reaction on a substrate.

Products generated by a plasma chemical reaction inside the reaction chamber also accumulate on an inner walls of the reaction chamber and a surface of the susceptor. As thin film formation is repeated, such deposits are gradually accumulated inside the plasma CVD apparatus. Subsequently, the deposits exfoliate from the inner walls and the susceptor surface and float inside the reaction chamber. The deposits then adhere onto substrates as foreign objects and cause impurity contamination, which results in defects.

To remove unwanted deposits adhering to the inner walls of the reaction chamber, in-situ cleaning which cleans inside the reaction chamber while the reaction chamber is in operation is effective. Chamber-cleaning (removal of unwanted extraneous matters and deposits remaining on the inner walls of the reaction chamber) is to bring a cleaning gas, which is selected according to the extraneous matter type, into the reaction chamber, to generate active species by a plasma decomposition reaction, and to remove the deposits by gasifying the deposits. For example, if silicon oxide or silicon nitride, or tungsten or its nitride or its silicide adheres, a gas containing fluorine such as $CF_4$, $C_2F_6$, $C_3F_8$ or $NF_3$ is used as a cleaning gas. In that case, active species of fluorine atoms (fluorine radicals) or active species containing fluorine react with the matters adhering to the inner walls of the reaction chamber, and their reaction products are discharged outside the reaction chamber in the form of gaseous matters.

In U.S. Patent No.4,960,488 issued on Oct. 2,1990, a method is disclosed to efficiently conduct chamber-cleaning of a capacitive coupled plasma CVD apparatus by combining a process for forming a cleaning plasma between narrowly distanced upper and lower electrodes under relatively high pressure and conducting localized cleaning and a process for producing a cleaning plasma between widely distanced upper and lower electrodes under relatively low pressure and conducting wide-range cleaning. The chamber-cleaning in this case is an in-situ plasma cleaning method by bringing cleaning gas into the reaction chamber, applying radio-frequency power to an area between upper and lower electrodes to excite a cleaning gas in a plasma state and to generate active species of fluorine atoms or active species containing fluorine, and removing deposits inside the reaction chamber. In particular, the object of the above invention is to highly efficiently conduct cleaning of the side walls of the chamber or a perimeter of the upper electrode, which controls the cleaning rate itself in the in-situ plasma cleaning method, and conduct cleaning of an exhaust system.

A weak point of the plasma CVD apparatus using the in-situ plasma cleaning method is that heavy ion bombardment is generated between the electrodes by radio-frequency (RF) power applied to the cleaning gas, because a plasma excitation device used for film forming is also used for activation of a cleaning gas. As a result, unwanted by-products (for example, aluminum fluoride if electrodes are made of an aluminum alloy) are formed. Because the by-products float, or surface layers of the electrode surface attacked by ion bombardment are exfoliated and fall on the substrate, impurity contamination is caused. Attacked parts need to be cleaned or replaced regularly. Because such maintenance work is required, an apparatus throughput declines and operation cost increases.

To solve the problem in ion bombardment in the in-situ plasma cleaning method, a remote plasma cleaning method in which plasma is generated outside a reaction chamber and a cleaning gas is activated by a plasma generated was developed. In U.S. Patent No.5,788,799 issued on Aug. 4,1998, a remote plasma cleaning method, in which a cleaning gas ($NF_3$) is excited to a plasma state by microwaves and activated inside an external discharge chamber isolated from the reaction chamber, was disclosed. In that invention, flow-controlled $NF_3$ is dissociated and activated by an external microwave generating source, and fluorine active specifies generated by the dissociation/activation of $NF_3$ are brought into the reaction chamber through a conduit tube and decompose and remove extraneous matters adhering to the inner wall surface of the reaction chamber.

Due to the increased capacity of the reaction chamber as the diameter of semiconductor substrates has become larger in recent years, an amount of remaining deposits needed to be cleaned increases and the time required for cleaning tends to increase. If the time required for cleaning increases, the number of substrates processed per unit time (throughput) declines. As a result, the throughput of the apparatus declines. Consequently, conducting cleaning efficiently is necessary. In the above-mentioned U.S. Patent No.5,788,799, a method of conducting chamber-cleaning efficiently by improving a removal rate of deposits adhering onto the surface of the reaction chamber by setting up a temperature-controlled ceramic liners adjacent to the inner walls of the reaction chamber, has been disclosed.

However, the present inventors believe that the above invention has the following disadvantages: First, when temperature-controlled ceramic liners are used, resistance-heating heater wires for heating are required to be installed inside the ceramic liners and the costs of this are commercially high. Additionally, to conduct chamber-cleaning efficiently, it is required to determine which area inside the reaction chamber most controls the cleaning rate. No consideration is given to this aspect at all in the aforesaid invention. In fact, the manner of deposits adhering to the inner walls of the reaction chamber varies depending on the method of deposition used; high-density plasma CVD, capacitive coupled plasma CVD, or thermal CVD. Naturally, an area controlling the cleaning rate differs between in-situ plasma cleaning in a capacitive coupled plasma CVD apparatus described in the above-mentioned U.S. Patent No.4,960,488 and the cleaning described in U.S. Patent No.5,788,799, in which remote plasma cleaning is used for a capacitive coupled plasma CVD apparatus.

Summary of the Invention

Consequently, an aim of the present invention is to provide a plasma CVD apparatus conducting self-cleaning at a high chamber-cleaning rate, and a method for conducting such self-cleaning.

Another aim of the present invention is to provide a plasma CVD apparatus conducting self-cleaning with optimized chamber-cleaning frequencies and a method for conducting such self-cleaning.

Still another aim of the present invention is to provide a plasma CVD apparatus conducting self-cleaning having no impurity contamination problems and a method for conducting such self-cleaning.

An additional aim of the present invention is to provide a plasma CVD apparatus conducting self-cleaning having a high throughput and a method for conducting such self-cleaning.

According to one accept of the present invention there is provided a plasma CVD apparatus comprising: (i) a reaction chamber; (ii) a susceptor for placing thereon and heating an object-to-be-processed, said susceptor being disposed inside the reaction chamber and constituting one of two electrodes for generating a plasma; (iii) a showerhead for discharging a reaction gas or a cleaning gas inside the reaction chamber, said showerhead being disposed in parallel to the susceptor and constituting the other electrode for generating a plasma; (iv) a heater for heating the showerhead to a designated temperature; and (v) a radio-frequency power source electrically connected to one of the susceptor or the showerhead. By heating directly the showerhead during the self-cleaning, the cleaning rate can increase, and by heating directly the showerhead during the process, a film deposited on the showerhead does not generate particle dusts for a long period, reducing cleaning frequencies.

In the above, in consideration of preventing particle contamination by ion bombardment, the plasma CVD apparatus may further comprise a remote plasma discharge device for activating a cleaning gas upstream of the reaction chamber, wherein said remote plasma discharge device is disposed outside the reaction chamber.

In an embodiment, the heater may be provided with and controlled by a controller programmed to heat the showerhead at a temperature of 200°C to 400°C (including 225°C, 250°C, 275°C, 300°C, 325°C, 350°C, 375°C, and a range including any of the foregoing). For example, even if the susceptor is heated to 500°C or higher, the showerhead is not heated to 200°C or higher without direct conductive heating. Heat transfer via a gas or radiation heating is not sufficient to heat the showerhead to 200°C or higher. In order to accurately control the temperature of the showerhead, the controller may comprise a detector for detecting the temperature of the showerhead. In an embodiment, the heater includes, but is not limited to, a sheath heater disposed in the vicinity of an outer periphery of the showerhead. Additionally, the temperature control over the showerhead surface may include not only heating but also cooling. In order to control the temperature in the above range, for example, both heating and cooling can be conducted. Cooling can be accomplished by a cooling jacket, for example.

In an embodiment, the susceptor may have a surface area configured to have a ratio of the surface area of the susceptor to a surface area of the object-to-be-processed in the range of 1.08 to 1.38. The ratio of the surface area of the showerhead to the surface area of the object is related to the cleaning rate and the evenness of a film deposited on an object (substrate). The greater the showerhead surface, the higher the cleaning rate becomes, but the worse the evenness of a film becomes. The above range may be preferable, although a preferable range varies (e.g., in the range of 1.05-1.50) depending on the type of film, reactor, and gas, and processing/cleaning conditions.

In an embodiment, the showerhead and the susceptor are configured to have a ratio of a surface area of the showerhead to a surface area of the susceptor in the range of 1.05 to 1.44. The ratio of the surface area of the showerhead to the surface area of the susceptor is related to the cleaning rate. The greater the showerhead surface, the higher the cleaning rate becomes, but the cleaning rate reaches a plateau after the above range. However, the above range may vary (e.g., in the range of 1.05-1.50) depending on the type of film, reactor, and gas, and processing/cleaning conditions.

The plasma CVD apparatus may further comprise a transfer chamber for loading an object-to-be-processed and unloading a processed object, wherein the transfer chamber is disposed co-axially with the reaction chamber and provided with an inert gas supplier for introducing an inert gas into the transfer chamber. In an embodiment, the reaction chamber may further comprise: (i) an elevating/descending drive for moving the susceptor vertically between the reaction chamber and the transfer chamber; (ii) a divider ring for separating the reaction chamber and the transfer chamber, said dividing ring being an insulator and surrounding the susceptor during the process, wherein there is a gap between the susceptor and the divider ring, through which an inert gas flows from the transfer chamber to the reaction chamber during the process; and (iii) a circular duct for discharging a gas from the reaction chamber, said duct being disposed along an inner wall of the reaction chamber in the vicinity of the outer periphery of the showerhead, wherein there is a gap between a lower edge of the circular duct and the divider ring, through which a gas is discharged from the reaction chamber. According to the above structures, the reaction space can be reduced while improving operability.

The present invention can equally be applied to a self-cleaning method for a plasma CVD apparatus. In an embodiment, the method may comprise the steps of: (i) after unloading an object processed in a reaction chamber, heating a showerhead to a temperature of 200°C to 400°C; (ii) introducing a cleaning gas into the reaction chamber; and (iii) cleaning the reaction chamber by plasma reaction using the cleaning gas. In the above, the cleaning gas can be activated in a remote plasma chamber upstream of the reaction chamber. Further, heating step can be conducted by heating in the vicinity of an outer periphery of the showerhead. In another embodiment, the method may further comprise heating the showerhead to a temperature of 200°C to 400°C while processing the object in the reaction chamber, thereby reducing self-cleaning frequencies. Further, as described with respect to the apparatus, a susceptor disposed inside the reaction chamber may have a surface area configured to have a ratio of the surface area of the susceptor to a surface area of an object-to-be-processed in the range of 1.08 to 1.38. Additionally, the showerhead and a susceptor disposed inside the reaction chamber may be configured to have a ratio of a surface area of the showerhead to a surface area of the susceptor in the range of 1.05 to 1.44.

In another embodiment, the present invention provides a method for self-cleaning a plasma CVD apparatus comprising the steps of: (i) selecting a susceptor having a ratio of a surface area of the susceptor to a surface area of an object-to-be-processed in the range of 1.08 to 1.38; (ii) selecting a showerhead having a ratio of a surface area of a showerhead to a surface area of the susceptor in the range of 1.05 to 1.44; (iii) processing an object placed on the susceptor; and (iv) initiating self-cleaning by (a) controlling a temperature of the showerhead within the range of 200°C to 400°C; (b) activating a cleaning gas and placing resultant active cleaning species in a reaction chamber; and (c) generating a plasma in the reaction chamber, thereby conducting self-cleaning at a designated pressure. As described with respect to the apparatus, the processing step may include heating the showerhead to a temperature of 200°C to 400°C. Further, the method may further comprise optimizing self-cleaning frequencies based on a maximum thickness of a film deposited on the showerhead which does not cause particle contamination at a temperature of 200°C to 400°C and a cleaning speed at a temperature of 200°C to 400°C.

For purposes of summarizing the invention and the advantages achieved over the prior art, certain aims and advantages of the invention have been described above. Of course, it is to be understood that not necessarily all such aims or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other aims or advantages as may be taught or suggested herein.

Further non-limiting aspects, features and advantages of this invention will become apparent from the detailed description of the preferred embodiments which follow.

Brief Description of the Drawings

These and other features of this invention will now be described with reference to the drawings of preferred embodiments which are intended to illustrate and not to limit the invention.

FIG. 1 is a schematic view of a conventional capacitive coupled plasma CVD apparatus having a self-cleaning mechanism.

FIG. 2 is a schematic view of an embodiment of a plasma CVD apparatus conducting self-cleaning according to the present invention.

FIG. 3 is a graph showing the relationship between upper electrode temperatures and cleaning rates in an embodiment.

FIG. 4 is a graph showing the relationship between cleaning rates and film thickness non-uniformity with respect to lower electrode areas/substrate areas in an embodiment.

FIG. 5 is a graph showing the relationship between cleaning rates and upper electrode areas/lower electrode areas.

FIG. 6 is a schematic view of another embodiment of a plasma CVD apparatus conducting self-cleaning according to the present invention.

In the drawings, the symbols used are as follows: 1: Object-to-be-processed; 2: Reaction chamber; 3: Susceptor; 4: Showerhead; 5: Piping; 6: Valve; 7: Opening; 8: Radio-frequency power source; 9: Output cable; 10: Impedance matching box; 11: Opening; 12: Piping; 13: Remote plasma discharge device; 14: Piping; 15: Air-cooling fan; 16: Sheath heater; 18: Radio-frequency power source; 20: Exhaust port; 21: Conductance regulating valve; 22: Thermocouple; 23: Bandpass filter; 24: Solid state relay; 25: Temperature controller; 26: AC power source.

Detailed Description of the Preferred Embodiment

The present invention can be applied to various embodiments including, but not limited to, the foregoing embodiments. For example, the present invention includes the following embodiments:

1) A plasma CVD apparatus which conducts self-cleaning comprises: (i) a reaction chamber, (ii) a susceptor disposed inside said reaction chamber, which is used for placing thereon and heating an object and used as one of two electrodes used for generating a plasma, (iii) a showerhead disposed opposing to and in parallel to said susceptor, which is used for emitting a reaction gas flow toward said object and used as the other electrode for generating a plasma, (iv) a temperature controlling mechanism for controlling a temperature of said showerhead at a given temperature, (v) a remote plasma discharge device provided outside said reaction chamber, which is used for activating a cleaning gas remotely, and (vi) a radio-frequency power-supplying means electrically connected to one of said susceptor or said showerhead.

2) A plasma CVD apparatus which conducts self-cleaning comprises: (i) a reactor, (ii) a susceptor disposed inside said reactor, which is used for placing thereon and heating an object and used as one of two electrodes for generating a plasma, (iii) an elevating/descending means for moving said susceptor up and down, (iv) a showerhead disposed at a ceiling of said reactor and opposing to and in parallel to said susceptor, which is used for emitting a reaction gas flow toward said object and used as the other electrode for generating a plasma, (v) a duct means positioned near the periphery of said showerhead, which is provided circularly along the inner walls of said reactor, (vi) an insulator dividing plate coaxial with said duct means, which is disposed so as to form a slight gap between the bottom of the duct means and the insulator dividing plate, and a slight gap between said susceptor and the dividing plate at the time of deposition, said dividing plate virtually dividing said reactor into a reaction chamber and a wafer handling chamber (WHC), (vii) a means for bringing an inactive gas into said wafer handling chamber (WHC), which is also used as a means for letting the inactive gas flow in the direction from the WHC to the reaction chamber through the gap formed between said insulator dividing plate and said susceptor at the time of deposition, (viii) a temperature controlling mechanism for controlling a temperature of said showerhead at a given temperature, (ix) a remote plasma discharge device disposed outside said reactor, which is used for activating a cleaning gas remotely, and (x) a radio-frequency power supplying means electrically connected to either of said susceptor or said showerhead.

3) In the plasma OVO apparatus according to Item 1 or Item 2, said given temperature is in the range of 200°C to 400°C.

4) In the plasma CVD apparatus according to Item 1 or Item 2, said temperature controlling mechanism comprises one heating means or more, which is arranged adjacently to said showerhead, a temperature measuring means, and a temperature controlling means coupled to said heating means and said temperature measuring means.

5) In the plasma CVD apparatus according to Item 4, said heating means is a sheath heater and said temperature means is a thermocouple.

6) In the plasma CVD apparatus according to Item 1 or Item 2, a ratio of the surface area of said susceptor to the surface area of said object is in the range of 1.08 to 1.38.

7) In the plasma CVD apparatus according to Item 1 or Item 2, a ratio of the surface area of said showerhead to the surface area of said susceptor is in the range of 1.05 to 1.44.

8) A method for conducting self-cleaning efficientiy using the plasma CVD apparatus according to Item 1, comprises: (i) a process of selecting a susceptor having a ratio of the surface area of said susceptor to the surface area of said object in the range of 1.08 to 1.38, (ii) a process of selecting a showerhead having a ratio of the surface area of said showerhead to the surface area of said susceptor in the range of 1.05 to 1.44, (iii) a process of controlling a temperature of said showerhead within the range of 200°C to 400°C, (iv) a process of activating a cleaning gas using said remote plasma discharge device and bringing active cleaning species into said reaction chamber, (v) a process of generating a plasma in a reaction area between said susceptor and said showerhead, and (vi) a process of controlling the pressure inside said reaction chamber.

9) The method according to Item 8 further includes a process of optimizing self-cleaning frequencies.

10) In the method according to Item 9, the process of optimizing frequencies of self-cleaning comprises a process of finding the upper limit of cumulative film thickness which is continuously processible, and a process of finding the maximum cleaning cycles by dividing said upper limit by the film thickness.

Verification 1

The inventors of the present invention have discovered that an area which controls the cleaning treatment rate is the surface of a showerhead (an upper electrode}, from an experiment using remote plasma cleaning for a capacitive coupled plasma CVD apparatus. The experiment is described below.

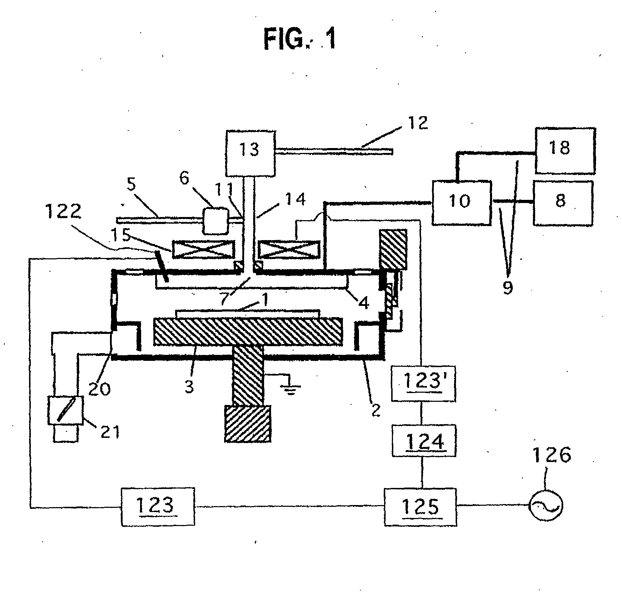

The apparatus used for the experiment is shown in Fig. 1. Fig. 1 shows a schematic view of the capacitive coupled plasma CVD apparatus, which has been used industrially up to now. This apparatus is a capacitive coupled plasma CVD apparatus for 300mm-substrate processing, which executes remote plasma cleaning.

Inside a reaction chamber 2, a susceptor 3 for placing thereon an object-to-be-processed 1 such as glass or silicon substrates is disposed. The susceptor is made of preferably ceramic or aluminum alloy, and inside the susceptor, a resistance-heating type heater is embedded. Additionally, the susceptor is also used as a lower electrode for generating a plasma. At a position opposing to and in parallel to the susceptor, a showerhead 4 for introducing a reaction gas uniformly onto the object-to-be-processed is disposed. The showerhead 4 is also used as an upper electrode for generating a plasma. On the side wall of the reaction chamber 2, an exhaust port 20 is provided. The exhaust port 20 is communicatively connected to a vacuum pump (not shown) through a conductance regulating valve 21.

Outside the reaction chamber 2, a remote plasma discharge device 13 is provided and is connected to an opening 7 of the showerhead 4 through piping 14. A cleaning gas source (not shown) is coupled with the remote plasma discharge device 13 through piping 12. To an opening 11 of the piping 14, one end of piping 5 is attached via a valve 6. The other end of the piping 5 is attached to a reaction gas source (not shown). Radio-frequency power sources (8, 18) for generating a plasma are connected with the showerhead 4 via a matching circuit 10 through an output cable 9. In this case, the susceptor 3 is grounded. Radio frequency power sources (8, 18) are able to supply power from hundreds kHz to tens MHz, and preferably, to improve film quality controllability, different frequencies are used for the radio-frequency power sources.

On the atmosphere side of the showerhead 4, an air-cooling fan 15 for preventing temperature changes of the showerhead 4 is provided. In the top plate of the reaction chamber 2, a thermocouple 122 for measuring a temperature of the showerhead 4 is embedded. The air-cooling fan 15 is connected with the temperature controller 125 via a bandpass filter 123' and a solid state relay 124. The thermocouple 122 is connected with the temperature controller 125 via the bandpass filter 123. The temperature controller 125 is connected with an AC power source.

After its flow is controlled by a mass flow controller (not shown) at a fixed flow rate, the reaction gas 5 for forming film on the surface of the object-to-be-processed 1 is supplied to the showerhead 4 through the piping 5, via the valve 6 and then passing through the opening 7. The reaction gas brought inside the reaction chamber 2 is excited to a plasma state by radio-frequency power supplied from the radio-frequency power sources (8, 18), and cause a chemical reaction on the surface of the object-to-be-processed 1. The film generated by the chemical reaction adheres to the surface of the showerhead 4 or the inner walls of the reaction chamber and others in addition to the object-to-be-processed 1.

After deposition on the object-to-be-processed 1 is completed and the object 1 is carried out from the reaction chamber 2 by the transfer means (not shown), cleaning treatment is started. A cleaning gas for cleaning deposits inside the reaction chamber comprises a gas containing fluorine, for example, $C_2F_6+O_2$, $NF_3+Ar$, $F_2+Ar$, etc. Controlled at a given flow, the cleaning gas is brought into the remote plasma discharge device 13 through the piping 12. After activated by a plasma inside the remote plasma discharge device, the cleaning gas is brought into the opening 7 through the piping 14. The cleaning gas brought into the reaction chamber 2 from the opening 7 is supplied inside the reaction chamber 2 equally via the showerhead 4 and chemically reacts with the deposits adhered to the inner walls of the reaction chamber 2 or the surface of the showerhead 4, etc. The deposits are gasified and discharged outward from the exhaust port 20 of the reaction chamber 2 through the conductance regulating valve 21 by the vacuum pump (not shown). In the capacitive coupled plasma CVD apparatus shown in Fig. 1, by the air-cooling fan 15 disposed on the atmosphere side of the showerhead 4, a temperature of the showerhead 4 is controlled at a constant temperature in the range of approximately 70°C to 150°C. As a result, a rise in temperature of the showerhead can be controlled, and changes in the quality (film thickness or film density, etc.) of the film generated can be prevented.

An experiment using the plasma CVD apparatus shown in Fig. 1 is described below. Under deposition conditions where the TEOS flow was 250sccm, the $O_2$ flow was 2.3slm, the distance between upper & lower electrodes was 10mm, the upper and lower electrodes diameter was Ø350mm, the chamber pressure was 400Pa, the radio-frequency power (13.56MHz) was 600W, the radio-frequency power (430kHz) was 400W, the susceptor temperature was 400°C, the showerhead temperature was 150°C, and the reaction chamber inner wall temperature was 140°C, deposition of a plasma silicon oxide film on a Ø300mm silicon substrate was performed.

The following was observed immediately after deposition processing: On the surface of upper and lower electrodes on which ion bombardment was heavy, a dense film with high film density was deposited. On the side wall of the reaction chamber or near the periphery of the showerhead, which was distant from the upper and lower electrodes and on which ion bombardment was light, only powdery extraneous matters rather than a film were observed.

Subsequently, under the same deposition conditions, after deposition of a plasma silicon oxide film with a film thickness of 1μm, chamber-cleaning was conducted under the cleaning conditions of: $NF_3$ flow of 1slm, Ar flow of 2slm, distance between upper and lower electrodes of 14mm, chamber pressure of 670Pa, remote plasma source power of 2.7kW, susceptor temperature of 400°C, showerhead temperature of 150°C, and reaction chamber inner wall temperature of 140°C. After a film with a regular film thickness of 1μm was formed, cleaning of the reaction chamber under these conditions was determined to be completed in approximately 120 seconds. However, to examine the most difficult region to be cleaned, cleaning treatment was stopped in 60 seconds and inside the reaction chamber was observed.

As a result of the observation, it was discovered that the deposits remained most on the surface of the showerhead (upper electrode), while a film adhered to the susceptor and powdery deposit adhered to the side walls of the reaction chamber or near the periphery of the showerhead were nearly completely removed. This observation result can be understood qualitatively as follows:

The relationship between an Arrhenius reaction rate and a temperature regarding a chemical reaction can be expressed by the following formula:

$$k = A \exp(-E/RT) \tag{1}$$

where k is a rate constant, A is a frequency factor, E is activation energy, R is a gas constant, and T is an absolute temperature, respectively. In this case, k is a cleaning rate, and it is expected that A depends mainly on the partial pressure of fluorine radicals, and E is minimum energy necessary for reaction and depends on the density or composition of an extraneous matter.

Because powdery deposit adhering to the inner walls of the reaction chamber or near the periphery of the showerhead has low film density and its activation energy is low, the cleaning rate is high. Although deposit on the susceptor (lower electrode) surface has a high film density and is a dense film, the cleaning rate is high because the surface temperature of the deposit is high at 400°C. Deposit on the showerhead (upper electrode) surface is a dense film with high film density due to ion bombardment by a plasma, and because its surface temperature is low as compared with the susceptor's, the cleaning rate is thought to be lowest.

Furthermore, by conducting cleaning treatment for 110 seconds under the same deposition conditions and cleaning conditions, inside the reaction chamber was observed. As a result, although a film adhering near the center of the showerhead surface was completely removed, a film adhering near the outermost periphery of the showerhead surface remained. This is expected to be that a considerable amount of dense film adhered onto the outermost periphery of the showerhead surface, because a plasma was generated between an area near the periphery of the showerhead surface and the metal reaction chamber inner walls as well as between an area near the periphery of the showerhead surface and the susceptor during the deposition.

According to the above-mentioned experiments and observation, when chamber-cleaning of a capacitive coupled plasma CVD apparatus was conducted using remote-plasma-cleaning, it became clear that an area which controls cleaning treatment itself was the showerhead surface, particularly an area near the periphery of the showerhead.

Verification 2

The inventors of the present invention have discovered from the experiment described below that to increase a chamber-cleaning rate and to improve a throughput of the apparatus, controlling the temperature of the showerhead within the range of 200°C to 400°C is preferred.

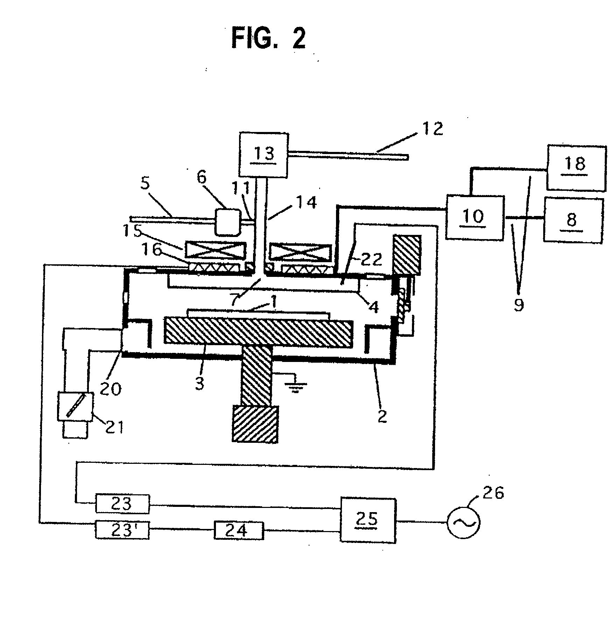

Fig. 2 shows a schematic view of Embodiment 1 of the capacitive coupled plasma CVD apparatus for conducting self-cleaning according to the present invention, which was used for this experiment. A difference of the apparatus shown in Fig. 2 from the apparatus shown in Fig. 1 is that the apparatus in this embodiment according to the present invention has a temperature controlling mechanism possessing a heater in the showerhead separately from a susceptor heater. The heater is used as a heat source for heating the showerhead actively to raise the temperature of the showerhead (upper electrode) surface 4. The temperature controlling mechanism comprises a sheath heater 16 for heating the showerhead 4, which is disposed near an upper portion of the showerhead 4, a thermocouple 22 for measuring the temperature of the showerhead 4, bandpass filters (23, 23') for avoiding the affect of radio-frequency power connected with the sheath heater 16 and the thermocouple 22 during the deposition, a solid state relay (or a thyristor) 24 for controlling power connected with the bandpass filter 23', a temperature controller 25, which is connected with the sheath heater 16 via the bandpass filter 23' and the solid state relay 24 and with the thermocouple 22 via the bandpass filter 23, respectively, and an AC power source 26 connected with the temperature controller 25. When the impact of radio-frequency noise is not high, the bandpass filters (23, 23') are not always required. Because the plasma CVD apparatus shown in Fig. 2 is a capacitive coupled plasma CVD apparatus for processing 200mm substrates, its dimensions are different from the dimensions of the apparatus shown in Fig. 1. All the components except for the above-mentioned temperature controlling mechanism are the same as the components of the apparatus shown in Fig. 1.

From formula (1), it is understood that by increasing the temperature T, the cleaning rate increases. 30 Given this factor, by setting the temperature of the showerhead (upper electrode) 4 at 80°C, 130°C, 165°C, 200°C, 300°C and 400°C, respectively, the chamber-cleaning rate for respective temperatures was measured.

First, under deposition conditions where the TEOS flow was 110sccm, the $O_2$ flow was 1.0slm, the distance between upper and lower electrodes was 10mm, the upper and lower electrodes diameter was Ø250mm, the chamber pressure was 400Pa, the susceptor temperature was 400°C, and the reaction chamber inner wall temperature was 120°C, deposition of plasma silicon oxide film was performed on a Ø200mm silicon substrate at a thickness of 1μm was performed. If deposition were performed by changing the temperature of the showerhead 4, the stress of plasma silicon oxide film deposited on the silicon substrate would be changed. To fix film stress at -150MPa, deposition was controlled by adjusting radio-frequency power.

After deposition was completed, the silicon substrate was carried out from the reaction chamber and cleaning was conducted. Under cleaning conditions where the $NF_3$ flow was 1slm, the Ar flow was 2slm, the distance between upper and lower electrodes was 14mm, the chamber pressure was 670Pa, the remote plasma source power was 2.7kW, the susceptor temperature was 400°C, the reaction chamber inner wall temperature was 120°C, chamber-cleaning was conducted. During the cleaning treatment, a weak plasma was generated by applying radio-frequency power (13.56MHz) at 50W, and luminescence intensity was monitored by a photoelectric transfer device. A cleaning endpoint was detected from the change of the luminescence intensity, and a cleaning rate was obtained.

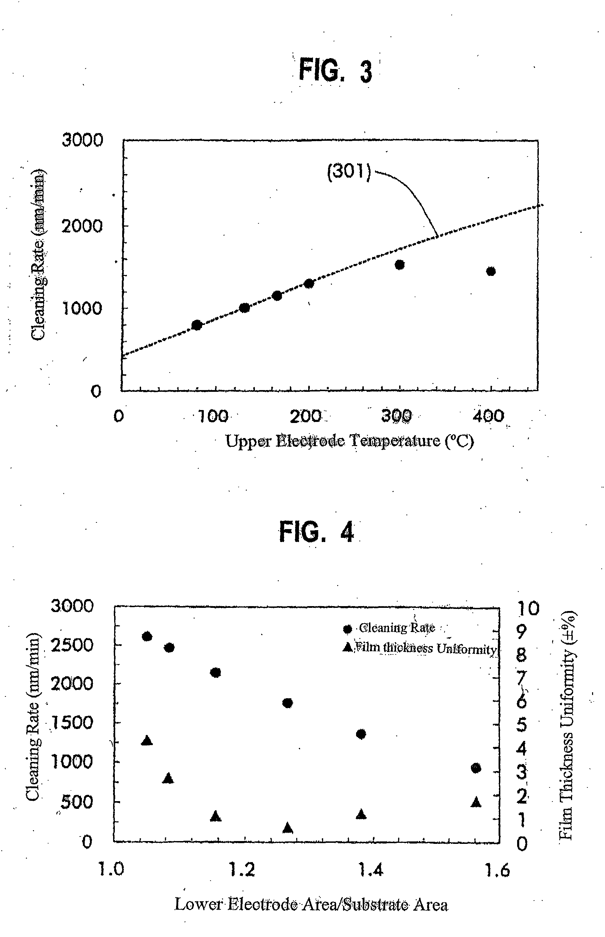

Fig. 3 is a graph showing the experimental results. Cleaning rates of the surface of the showerhead 4 at respective temperatures, 80°C, 130°C,165°C, 200°C, 300°C and 400°C are shown by black dots (• in the graph). The experimental results show that the cleaning rate increases as the temperature of the showerhead rises and that the cleaning rate reaches its peak at 300°C and slightly declines at 400°C. As the result of fitting the cleaning rates corresponding to 80°C, 130°C, 165°C and 200°C in the formula (1) ((301) in Fig. 3), the following formula (2) was obtained:

$$<\text{Cleaning Rate}> = 6.10 \times 10^3 \cdot \exp(-6.03 \times 10^3/RT) \qquad (2)$$

Formula (2) shows that the cleaning rate increases when the temperature T of the showerhead 4 rises. This formula cannot show a good representation when the temperature of the showerhead 4 exceeds 200°C. This is because the temperature for processing is preferably, but need not be, the same as the temperature for cleaning in order to accomplish a high throughput, and at a temperature exceeding 200°C during the process, the density of a film adhering onto the showerhead surface increases and an extremely dense film is formed, resulting in that the value for activation energy becomes larger than 6.03 kJ/mol in Formula (2). However, the temperature for cleaning can be different from the temperature for processing, and if the temperature for processing is lower than 200°C, and the temperature for cleaning exceeds 200°C, Formula (2) will show a good representation.

Additionally, the temperature control of the showerhead affects adherence of the film formed onto the showerhead 4 with the surface of the showerhead during deposition processing. The number of substrates processed by continuous execution without causing exfoliation differs depending on the temperature of the showerhead. The more the number of substrates continuously processible without cleaning, the higher the throughput of the apparatus becomes. Consequently, an experiment of examining a cleaning cycle in relation to the temperature of the showerhead surface was conducted.

Under the same above-mentioned conditions, deposition of a plasma silicon oxide film of 0.5 μm on a silicon substrate was performed. By setting the temperature of the showerhead at 80°C, 130°C, 165°C, 200°C, 300°C and 400°C, deposition processing was performed continuously at respective temperatures without conducting cleaning, and the number of substrates processed when film exfoliation from the showerhead surface occurred and dust generation was observed was checked.

As the results of the experiment, the number of substrates processed when dust generation was observed was 3, 5, 6, 11, 23 and 40 substrates or more for respective temperatures when the temperature of the showerhead was set at 80°C, 130°C, 165°C, 200°C, 300°C and 400°C, respectively (In the case of 400°C, up to 40th substrate was observed and no dust generation was observed.). The number increased as the temperature of the showerhead surface rose. From these results, it was found that the upper limit of continuously-processible cumulative film thickness is approximately 5µm when the temperature is 200°C, approximately 11µm when the temperature is 300°C, and 20µm or more when the temperature is 400°C. Once the upper limit of the cumulative film thickness is found, the maximum cleaning cycle for a certain film thickness to be processed can be determined. For example, when the temperature of the showerhead surface is set at 300°C, the maximum cleaning cycle will be 11 substrates when film with 11µm thickness is deposited per substrate. Although this cleaning cycle depends on the type of film deposited and roughness of the showerhead surface and other factors, in either situation, when the temperature of the showerhead rises, it can be said that film density increases, adherence increases and it becomes difficult for the film to exfoliate.

With the above-mentioned results, to increase the chamber-cleaning rate, it was indicated that, to increase a cleaning cycle and to improve a throughput of the apparatus, controlling the temperature of the showerhead at a temperature in the range of 200°C to 400°C was preferable (more preferably 250°C-350°C). Using the above as guidelines, a preferable temperature range of a showerhead under target cleaning conditions can be determined.

Verification 3

The inventors of the present invention have discovered that, to increase a chamber-cleaning rate and to improve the film thickness non-uniformity, controlling a ratio of a lower electrode area/a substrate area within the range of 1.08 to 1.38 is preferable.

It is thought that a cause for a particularly slow cleaning rate of the periphery of the showerhead surface is that a large amount of film with high density adheres to this area. Consequently, to alleviate concentration of a plasma on this area and to reduce the density and an amount of film adhering, an experiment for altering the ratio of a lower electrode area to a substrate area was conducted.

For this experiment, Embodiment 1 of the capacitive coupled plasma CVD apparatus according to the present invention, which is shown in Fig. 2, was used. Under deposition conditions where the TEOS flow was 110sccm, the $O_2$ flow was 1.0slm, the distance between upper and lower electrodes was 10mm, the upper and lower electrodes diameter was Ø250mm, the chamber pressure was 400Pa, the showerhead temperature was 130°C, the susceptor temperature was 400°C, and the reaction chamber inner wall temperature was 120°C, deposition of a plasma silicon oxide film of 1µm on a Ø200mm silicon substrate was performed. If deposition were performed by altering an area of the susceptor 3, stress of the plasma silicon oxide film formed on the silicon substrate would change. To fix the film stress at approximately -150MPa, deposition was controlled by adjusting radio-frequency power.

After deposition on each susceptor area was completed, the silicon substrate was carried out from the reaction chamber and cleaning was conducted under the cleaning conditions: an $NF_3$ flow of 1slm, an Ar flow of 2slm, a distance between upper and lower electrodes of 14mm, a chamber pressure of 670Pa, remote plasma source power of 2.7kW, a showerhead temperature of 130°C, a susceptor temperature of 400°C, and a reaction chamber inner wall temperature of 120°C. To confirm a cleaning endpoint, radio-frequency power (13.56MHz) was applied at 50W and a cleaning rate was obtained in the same manner as the above-mentioned. Additionally, the thickness of the silicon oxide film formed on the substrate was measured by a thickness interferometer, and film thickness non-uniformity was calculated by a formula shown below. Points to be measured were (x, y) coordinates with respect to the center of the substrate as the origin, which were nine points: (0, 0), (0, 97), (97, 0), (0, -97), (-97, 0), (0, 47), (47, 0), (0, -47), and (-47, 0). A unit of coordinates is mm. The film thickness non-uniformity was measured by the following:

(Film thickness non-uniformity (± %)) = {(Maximum value) — (Minimum value)) x 100/2/(Average value)

Fig. 4 shows the measurement results of cleaning rates of the reaction chamber and the film 20 thickness non-uniformity when the ratio of a susceptor (lower electrode) area to a substrate area was altered. The experimental results shown in Fig. 4 prove that the cleaning rate increases as a value for the susceptor area approaches a value for the substrate area. This is expected that a plasma is concentrated near the center and the density and the amount of deposits near the outermost periphery of the showerhead surface are reduced as the susceptor area becomes small. The film thickness non-uniformity declines as the susceptor area value approaches the substrate area value. For example, when a value for the susceptor area/a substrate area is 1.05, the film thickness non-uniformity is ±4.3%, which exceeds a standard value of ±3% generally demanded by semiconductor device manufacturing. When a value for the susceptor area/substrate area is 1.08, the film thickness non-uniformity is ±2.8%, which complies with the standard value. Consequently, from the experimental results, it was shown that if a value for the susceptor area/substrate area was in the range of 1.08 to 1.38 (more preferably 1.1-1.3), adherence of the film to the periphery was controlled, the cleaning rate increased and the film thickness non-uniformity was satisfactory.

Using the above as guidelines, a preferable value for the susceptor area/substrate area under target cleaning conditions can be determined.

Verification 4

The inventors of the present invention next have discovered that another method increased a chamber-cleaning rate by controlling a value for the upper electrode area/lower electrode area in the range of 1.05 to 1.44, from an experiment described below.

It is thought that a cause for a particularly slower rate of cleaning the periphery of the showerhead surface is because a great amount of dense film with high density adheres to this area. Given this factor, to alleviate concentration of a plasma on this area and to further reduce the density and the amount of the film, an experiment for altering the ratio of a showerhead (upper electrode) area to a susceptor (lower electrode) area was conducted.

For this experiment, Embodiment 1 of the capacitive coupled plasma CVD apparatus according to 10 the present invention, which is shown in Fig. 2, was used. Under deposition conditions where the TEOS flow was 110sccm, the $O_2$ flow was 1.0slm, the distance between upper and lower electrodes was 10mm, the lower electrode's diameter was Ø225mm, the chamber pressure was 400Pa, the showerhead temperature was 130°C, the susceptor temperature was 400°C, and the reaction chamber inner wall temperature was 120°C, deposition of a plasma silicon oxide film was performed at a thickness of 1μm on a Ø200mm silicon substrate. If deposition were performed by altering an area of the showerhead (upper electrode) 4, stress of the plasma silicon oxide film formed on the silicon substrate would change. To fix the film stress at approximately -150MPa, deposition was controlled by adjusting radio-frequency power.

After deposition on each upper electrode area was completed, the silicon substrate was carried out from the reaction chamber and cleaning was conducted. The chamber-cleaning was conducted under the cleaning conditions of: an $NF_3$ flow of 1slm, an Ar flow of 2slm, a distance between upper and lower electrodes of 14mm, a chamber pressure of 670Pa, a remote plasma source power of 2.7kW, a showerhead temperature of 130°C, a susceptor temperature of 400°C, and a reaction chamber inner wall temperature of 120°C. To confirm a cleaning endpoint, radio-frequency power (13.56MHz) was applied at 50W and a cleaning rate was obtained in the same manner as the above-mentioned (Verification 2).

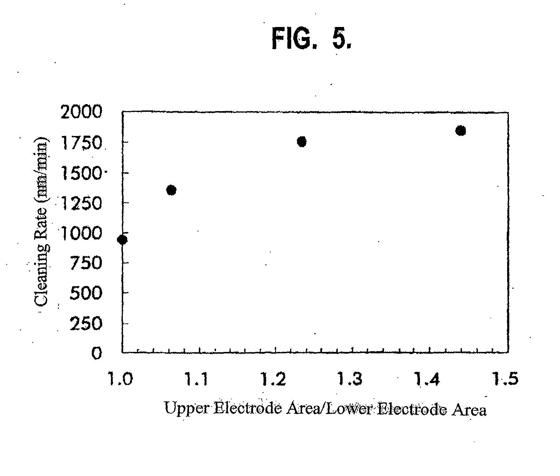

Fig. 5 shows the measurement results of cleaning rates of the reaction chamber when the ratio of an upper electrode area to a lower electrode area was altered. In either case, the film thickness non-uniformity did not exceed ±3%. The experimental results shown in Fig. 5 prove that the cleaning rate increases as the upper electrode area becomes large in relation to the lower electrode area. This is thought that, as the upper electrode area becomes large relatively to the lower electrode area, a plasma near the periphery of the upper electrode expands, the plasma density is reduced, and the density and the amount of deposits near the outermost periphery of the upper electrode surface are reduced. If a value for the upper electrode area/lower electrode area is in the range of 1.00 to 1.23, the increasing rate of the cleaning rate is large and improvement is remarkable. If values 1.23 and 1.44 are compared, the increasing rate of the cleaning rate is comparatively small. Not only a remarkable increase in the cleaning rate cannot be expected even if the showerhead area is increased further, but also it is not preferred because the dimensions of the apparatus increase. Consequently, the experimental results indicate that a value for the upper electrode area/lower electrode area in the range of 1.05 to 1.44 (including 1.10, 1.15, 1.20, 1.25, 1.30, 1.35, 1.40, and a range including any of the foregoing) is preferred, because adherence of the film to the periphery of the showerhead is controlled, the cleaning rate is increased and unnecessary increase in the apparatus dimensions is not involved.

Using the above as guidelines, a preferable value for the showerhead area/susceptor area under target cleaning conditions can be determined.

Description of Embodiment 2 according to the present invention

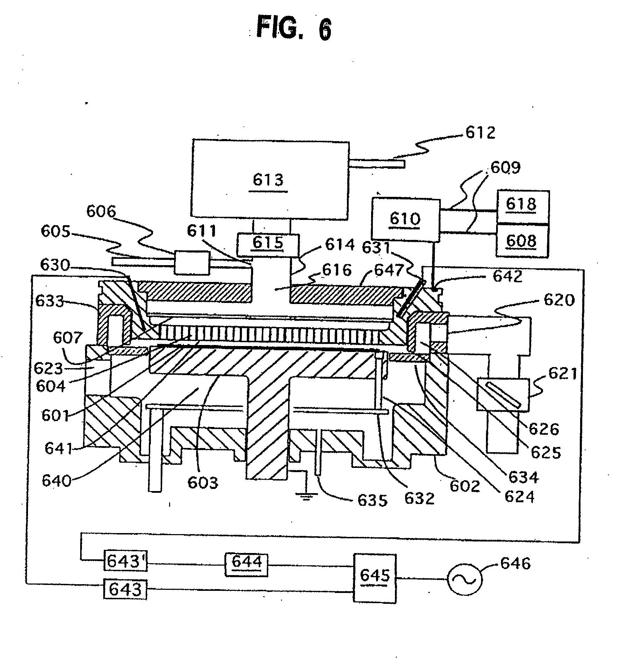

Fig. 6 shows Embodiment 2 of the capacitive coupled plasma CVD apparatus for conducting self cleaning according to the present invention. This apparatus is a capacitive coupled plasma CVD apparatus for conducting remote plasma cleaning to process 300mm substrates.

Inside a reactor, a susceptor 603 for placing an object-to-be-processed 601 such as glass or silicon substrates on it is set up. The susceptor 603 comprises preferably ceramic or aluminum alloy, inside which a resistance-heating heater is embedded. The susceptor 603 is also used as a lower electrode for generating a plasma. In this embodiment, the susceptor 603 has a diameter of 325mm and an area 1.17 times larger than that of an object-to-be-processed 601 with a diameter of Ø300mm. Within the range of 1.08 to 1.38 times, a susceptor of a different diameter can be used. A showerhead 604 for emitting reaction gases equally to the object-to-be-processed 601 is set up on the ceiling of the reactor and in parallel and opposing to the susceptor. The showerhead 604 is also used as an upper electrode for generating a plasma. In this embodiment, the showerhead has a diameter of 380mm and an area 1.37 times larger than that of the susceptor 803. Within the range of 1.05 to 1.44 times, a showerhead of different diameter can be used.

On the top of a showerhead 604, an alumina top plate 647 is provided. The showerhead 604 is supported by an alumina duct means 633 provided circularly along the inner wall surface of the reactor. A circular alumina dividing plate 634 is set up coaxially with the duct means 633 for forming a slight gap with the bottom of the duct means and a slight gap with the susceptor at the time of deposition. By the dividing plate 634, the reactor is practically divided into a reaction chamber and a WHC (Wafer Handling chamber). As just described, by using insulators for all components adjacent to the showerhead 604 inside the reactor, generating a plasma between the showerhead 604 and the reaction chamber inner wall can be prevented. It is sufficient if insulator components such as the above-mentioned top plate 647, the duct means 633 and the dividing plate 634 are made of ceramics, which meet requirements including insulation, heat resistance, corrosion resistance, plasma resistance and low dust generation. Other than alumina, aluminum nitride (AIN) or magnesia (MgO) can also be used.

Between the dividing plate 634 and the duct means 633, an exhaust gap 625 is formed. On the side wall of the duct means 633, an exhaust port 620 is provided. The exhaust port is communicatively connected with a vacuum pump (not shown) via a conductance regulating valve 621. On the side wall of the WHC made of aluminum alloy, an opening 623 for bringing/carrying an object-to-be-processed 601 in/out from the WHC is provided. Additionally, on a portion of the side wall 602, an inactive gas inlet 635 coupled with a means for bringing in inactive gas (not shown) is provided. The inactive gas (preferably, Ar or He) brought in from the inactive gas inlet 635 flows from the WHC to the reaction chamber side through a gap formed between the dividing plate 634 and the susceptor 603. By purging of this inactive gas, penetration of a reaction gas or a plasma beneath the susceptor 603 is prevented. The side wall 602, the duct means 633, the showerhead 604 and the top plate 647 are sealed by a sealing means such as an O-ring(s) and are completely separated from the atmosphere. Underneath the susceptor 603, a wafer lifting mechanism 632 is provided and supports multiple alumina wafer lift pins 624. The wafer lift pins 624 pass through the susceptor 603 and hold the edge of the object-to-be-processed 601. Mechanically coordinated with an elevating/descending mechanism (not shown) provided outside the reactor and moving up and down relative to each other, the susceptor and the wafer lifting mechanism place a semiconductor wafer 601 on the susceptor 603 or support the wafer in air.

Outside the reactor, a remote plasma discharge device 613 is set up, which is coupled with an opening 616 of the showerhead 604 via a valve 614 through piping 615. A cleaning gas source (not shown) is communicatively connected with the remote plasma discharge device 613 through piping 612. One end of the piping 615 is connected to an opening 611 of the piping 614 via a valve 606. The other end of the piping 605 is connected to a reaction gas source (not shown). Radio-frequency power sources (608, 618) for generating plasma is connected with the top 642 of the showerhead 604 via a matching circuit 610 through an output cable 609. In this embodiment, the susceptor 603 is grounded. The radio-frequency power sources (608, 618) can supply radio-frequency power of several hundred kHz to tens of MHz. Preferably, to improve film quality controllability, frequencies of the radio-frequency power sources (608, 618) vary.

As in Embodiment 1, Embodiment 2 according to the present invention has a temperature controlling mechanism for controlling a temperature of the surface of the showerhead (upper electrode) 604. The temperature controlling mechanism comprises a sheath heater 631 for heating the showerhead 604, which is embedded in the showerhead 604, a thermocouple 630 for measuring a temperature of the showerhead 604, bandpass filters (643, 643') for avoiding the affect of radio-frequency power connected with the sheath heater 631 and the thermocouple 630 during the deposition, a solid state relay (or a thyristor) 644 for controlling power connected with the bandpass filter 643', a temperature controller 645, which is connected with the sheath heater 631 via the bandpass filter 643' and the solid state relay 644 and with the thermocouple 630 via the bandpass filter 643, respectively, and an AC power source 646 connected with the temperature controller. When the impact of radio-frequency noise is not high, the bandpass filters (643, 643') are not always required.

The object-to-be-processed 601, which is a Ø300mm glass or silicon substrate placed on a vacuum handling robot (not shown) in a vacuum load lock chamber, is carried inside a WHC 640 from the opening 623 of the reactor wall 602. At this time, both the susceptor 603 set up in the WHC 640 and multiple wafer lift pins 624 attached on the wafer lifting mechanism 632 come down at a relatively low position to the substrate by the elevating/descending mechanism (not shown) such as a motor set up outside the reactor. The multiple lift pins 624 go up relatively from the surface of the susceptor 603 and hold near the edge of the substrate. Afterward, while placing the substrate 601 on its surface, the susceptor 603 goes up together with the wafer lifting mechanism 632 up to a position at which a distance between electrodes predetermined based on the deposition conditions is achieved. After being controlled at a given flow rate by a mass flow controller (not shown), a reaction gas for forming a film on the surface of the object-to-be-processed 601 is equally brought into a reaction area 641 from the piping 605, and then passing through the valve 606, the piping 614, the opening 616 of the top plate 647, a gas dispersing plate 607, and multiple gas exhaust-nozzles provided in the showerhead 604.

The reaction gas brought in the reaction area 641 is pressure-controlled and is excited into a plasma state by radio-frequency power of several hundred kHz to tens of MHz supplied by the radio-frequency power sources (608, 618). A chemical reaction occurs on the surface of the object-to-be-processed 601 and a desired film is formed. At the deposition, inactive gas such as He, Ar, or $N_2$ is brought into the WHC 640 from the inactive gas inlet 635. With this, the pressure inside the WHC 640 changes into positive pressure from the reaction area 641, and the flowing of the reaction gas into the WHO is prevented. As a result, the reaction gas can be used efficiently for deposition purpose as well as adhering of unwanted deposits onto the inner walls of the WHO 640 can be avoided. A flow of the inactive gas is controlled appropriately according to a reaction gas flow or pressure inside the reaction chamber.

After deposition processing is completed, the reaction gas and by-products remaining in the reaction 20 area are exhausted outside from an exhaust gap 625 through a gas path 626 inside the duct 633, then from the exhaust port 620. When the deposition processing is completed, the susceptor 603 and the wafer lifting mechanism 632 come down at a wafer handling position. As the susceptor comes down further from that position, the wafer lift pins 624 project above the surface of the susceptor 603 relatively to the position of the susceptor and hold the object-to-be-processed (semiconductor wafer) 601 in air. Afterward, the semiconductor wafer 601 is carried out outside load lock chamber (not shown) by a handling means (not shown) through the opening 623.

After deposition of one to multiple wafers is completed, self-cleaning for cleaning deposits adhering to portions exposed to the reaction gases inside the reaction area 641 is executed. After a flow of cleaning gas (for example, $C_2F_6+O_2$, $NF_3+Ar$, $F_2+Ar$, etc.) is controlled to a given flow rate, the cleaning gas is brought into the remote plasma discharge device 613 through the piping 612. The cleaning gas activated by the remote plasma discharge device 613 is brought into the opening 616 of the top plate 647 of the reactor through the piping 614 via the valve 615. The cleaning gas brought into the reactor from the opening 616 is equally dispersed to the reaction area 641 via the gas dispersing plate 607 and multiple gas exhaust-nozzles provided in the showerhead 604. The cleaning gas brought into reacts with the deposits adhering to the inner walls of the reaction chamber in the reaction area 641 and gasifies the deposits. Gasified deposits are exhausted outside from the exhaust gap 625 through the gas path 626 inside the duct 633, then from the exhaust port 620.

A method for improving cleaning efficiency according to the present invention is described below. The method includes a process for selecting a susceptor for which a value for the surface area of the susceptod the surface area of the object-to-be-processed is in the range of 1.08 to 1.38, a process for selecting a showerhead for which a value for the surface area of the showerhead/the surface area of the susceptor is in the range of 1.05 to 1.44, and a process for controlling the temperature of the showerhead within the range of 200°C to 400°C The process for limiting a ratio of the susceptor surface area to the area of the substrate to the range of 1.08 to 1.38 is specifically able to limit an actual area by controlling plasma generation by covering an extra susceptor area by a circular insulation plate as well in addition to changing the dimensions of the susceptor. The process for controlling a temperature of the showerhead within the range of 200°C to 400°C specifically implies supplying power to multiple sheath heaters 631 so that the temperature of the temperature controller 645 changes to a given temperature by responding to signals from the thermocouple 630. The thermocouple 630 sends the signals to the temperature controller 645 via the bandpass filter 643 to avoid the impact of radio-frequency power at the time of deposition. Responding to the signals sent, the temperature controller 645 supplies power to multiple sheath heaters 631 via the solid state relay 644 for regulating power and the bandpass filter 643 for avoiding the impact of radio-frequency power at the time of deposition.

Furthermore, the method includes a process for optimizing self-cleaning frequencies. The process specifically comprises a process for finding the upper limit of cumulative film thickness which is continuously processible and a process for finding the maximum cleaning cycle by dividing the upper limit by film thickness to be deposited on an object-to-be-processed. The process for finding the upper limit of cumulative film thickness which is continuously processible specifically implies that by performing deposition processing continuously without conducting cleaning, the number of substrates processed until film exfoliation from the showerhead surface occurs and dust generation is observed is checked. For example, when plasma silicon oxide film of 0.5µm is deposited as in the above-mentioned experiment (Verification 2), cumulative film thickness which is continuously processible is calculated as follows:

Continuously processible cumulative film thickness (µm) = 0.5 (µm) x (Maximum No. of substrates processed)

Embodiment

Using a conventional capacitive coupled plasma CVD apparatus shown in Fig. 1 and the capacitive coupled plasma CVD apparatus in Embodiment 2 according to the present invention shown in Fig. 6, comparative experiments of deposition rates, film thickness non-uniformity, cleaning rates, and cleaning cycle under conditions described below were conducted.

(1) Deposition conditions:

Deposition conditions for the conventional capacitive coupled plasma CVD apparatus shown in Fig. 1 were: a TEOS flow of 250sccm, an $O_2$ flow of 2.3slm, a distance between upper and lower electrodes of 10mm, a showerhead diameter of Ø350mm, a lower electrode diameter of Ø350mm, a chamber pressure of 400 Pa, a showerhead temperature of 150°C, a susceptor temperature of 400°C, a reaction chamber inner wall temperature of 140°C, a radio-frequency power (13.56MHz) at 600W and radio-frequency power (430kHz) at 400W. Under these deposition conditions, deposition of a plasma silicon oxide film was performed at a thickness of 1μm on a Ø300mm silicon substrate.

Deposition conditions for the capacitive coupled plasma CVD apparatus according to the present invention shown in Fig. 6 were: a TEOS flow of 250sccm, an $O_2$ flow of 2.3slm, a distance between upper and lower electrodes of 10mm, a showerhead diameter of Ø380mm, a lower electrode diameter of Ø325mm, a chamber pressure of 400Pa, a showerhead temperature of 300°C, a susceptor temperature of 400°C, a reaction chamber inner wall temperature of 230°C, a WHC inner wall temperature of 150°C, a radio-frequency power (13.56MHz) at 600W and radio-frequency power (430kHz) at 400W. Under these deposition conditions, deposition of a plasma silicon oxide film was performed at a thickness of 1μm on a Ø300mm silicon substrate:

(2) Cleaning conditions:

Cleaning conditions for the conventional capacitive coupled plasma CVD apparatus shown in Fig. I were: an $NF_3$ flow of 1slm, an Ar flow of 2slm, a distance between upper and lower electrodes of 14mm, a chamber pressure of 670Pa, a remote plasma source power of 2.7kW, a showerhead temperature of 150°C, and a susceptor temperature of 400°C. To confirm a cleaning endpoint, by applying radio-frequency power (13.56MHz) at 50W (Verification 2), the cleaning rate was obtained in the same method as used for the above-mentioned (Verification 2).

Cleaning conditions for the capacitive coupled plasma CVD apparatus according to the present invention shown in Fig. 6 were: an $NF_3$ flow of 1slm, an Ar flow of 2slm, a distance between upper and lower electrodes of 14mm, a chamber pressure of 670Pa, a remote plasma source power of 2.7kW, a showerhead temperature of 300°C, a susceptor temperature of 400°C, a reaction chamber inner wall temperature of 230°C, and a WHO inner wall temperature of 150°C. To confirm a cleaning endpoint, by applying radio-frequency power (13.56MHz) at 50W (Verification 2), the cleaning rate was obtained in the same method as used for the above-mentioned (Verification 2).

A method for measuring film thickness and a method for calculating film thickness non-uniformity were the same as the above-mentioned (Verification 3). Film thickness, however, was measured at (x, y) coordinates with respect to the center of the substrate as the origin, which were nine points: (0, 0), (0, 147), (147, 0), (0, -147), (-147, 0,), (0, 73), (73, 0), (0, -73) and (-73, 0).

Experimental results are shown in Table 1 below.

Table 1

|  | A | B | C | D | E | F |
|---|---|---|---|---|---|---|
| Conventional | 749 | 1.5 | -150 | 503 | 3 | 12.6 |
| Example | 803 | 1.5 | -150 | 1498 | 11 | 19.3 |
| A: Deposition Rate (mm/min.) | | | | | | |
| B: Film Thickness Non-uniformity (±%) | | | | | | |
| C: Film Stress (MPa) | | | | | | |
| D: Cleaning Rate (mm/min.) | | | | | | |
| E: Cleaning Cycle (pcs./cleaning) | | | | | | |
| F: Throughput (pcs./hr) | | | | | | |

According to the experimental results, as compared with the Conventional Example, in the Example, the deposition rate improved by approximately 7%, the cleaning rate improved by approximately 300%, and the cleaning cycle improved by approximately 4 times. These results indicate that the apparatus according to this embodiment of the present invention is able to improve the deposition rate, the cleaning rate and the cleaning cycle without impairing film thickness non-uniformity and film stress, As a result, the maximum number of substrates processed (on which deposition of a plasma silicon oxide film of 1μm is continuously performed) per hour and per apparatus, was increased to 19.3 pieces/hour using the apparatus of the Example according to the present invention, as compared with the maximum number of substrates continuously processed using the conventional apparatus of 12.6 pieces/hour. It was found that the throughput of the apparatus was improved by 50% or more.

The aspect of the present invention is not limited to a plasma CVD apparatus for deposition of a plasma silicon oxide film (SiO). For example, the present invention can be applied to a plasma CVD apparatus for deposition of insulation films such as silicon nitride film (SiN), silicon oxide nitride film (SiON), silicon carbide film (SiC), and silicon oxide carbide film (SiOC) or for deposition of conductive films such as tungsten silicide film (WSi) and titanium nitride film (TiN).

Effects

In an embodiment of the present invention, the cleaning efficiency of an upper electrode surface which controls the cleaning treatment rate of a capacitive coupled plasma CVD apparatus can be improved, and a plasma CVD apparatus with high cleaning rates of the entire inner walls of the chamber can be provided.

Additionally, by enabling adherence of the upper electrode surface and deposits to increase, chamber-cleaning frequencies can be reduced and optimized.

As a result, a plasma CVD apparatus and a method, which have extremely low impurity contamination and achieve a high throughput, can be provided.

It will be understood by those of skill in the art that numerous and various modifications can be made without departing from the spirit of the present invention. Therefore, it should be clearly understood that the forms of the present invention are illustrative only and are not intended to limit the scope of the present invention.

**Claims**

1. A plasma CVD apparatus comprising:

   a reaction chamber;
   a susceptor for placing thereon and heating an object-to-be-processed, said susceptor being disposed inside the reaction chamber and constituting one of two electrodes for generating a plasma;
   a showerhead for discharging a reaction gas or a cleaning gas inside the reaction chamber, said showerhead being disposed in parallel to the susceptor and constituting the other electrode for generating a plasma;
   a heater for heating the showerhead to a designated temperature; and
   a radio-frequency power source electrically connected to one of the susceptor or the showerhead.

2. The plasma CVD apparatus according to Claim 1, further comprising a remote plasma discharge device for activating a cleaning gas upstream of the reaction chamber, said remote plasma discharge device being disposed outside the reaction chamber.

3. The plasma CVD apparatus according to Claim 1 or 2, wherein said heater is provided with and controlled by a controller programmed to heat the showerhead at a temperature of 200°C to 400°C.

4. The plasma CVD apparatus according to Claim 3, wherein said controller comprises a detector for detecting the temperature of the showerhead.

5. The plasma CVD apparatus according to any preceding Claim, wherein said heater is a sheath heater disposed in the vicinity of an outer periphery of the showerhead.

6. The plasma CVD apparatus according to any preceding Claim, wherein said susceptor has a surface area configured to have a ratio of the surface area of the susceptor to a surface area of the object-to-be-processed in the range of 1.08 to 1.38.

7. The plasma CVD apparatus according to any preceding Claim, wherein said showerhead and said susceptor are configured to have a ratio of a surface area of the showerhead to a surface area of the susceptor in the range of 1.05 to 1.44.

8. The plasma CVD apparatus according to any preceding Claim, further comprising a transfer chamber for loading an object-to-be-processed and unloading a processed object, said transfer chamber being disposed co-axially with the reaction chamber and provided with an inert gas supplier for introducing an inert gas into the transfer chamber, wherein the reaction chamber further comprises:

   an elevating/descending drive for moving the susceptor vertically between the reaction chamber and the transfer chamber;
   a divider ring for separating the reaction chamber and the transfer chamber, said dividing ring being an insulator and surrounding the susceptor during the process, wherein there is a gap between the susceptor and the divider ring, through which an inert gas flows from the transfer chamber to the reaction chamber during the process; and

a circular duct for discharging a gas from the reaction chamber, said duct being disposed along an inner wall of the reaction chamber in the vicinity of the outer periphery of the showerhead, wherein there is a gap between a lower edge of the circular duct and the divider ring, through which a gas is discharged from the reaction chamber.

9. A self-cleaning method for a plasma CVD apparatus comprising the steps of:

after unloading an object processed in a reaction chamber, heating a showerhead to a temperature of $200°C$ to $400°C$;
introducing a cleaning gas into the reaction chamber; and
cleaning the reaction chamber by plasma reaction using the cleaning gas.

10. The method according to Claim 9, wherein the cleaning gas is activated in a remote plasma chamber upstream of the reaction chamber.

11. The method according to Claim 9 or 10, wherein the heating step is conducted by heating in the vicinity of an outer periphery of the showerhead.

12. The method according to any one of Claims 9-11, further comprising heating the showerhead to a temperature of $200°C$ to $400°C$ while processing the object in the reaction chamber, thereby reducing self-cleaning frequencies.

13. The method according to any one of Claims 9-12, wherein a susceptor disposed inside the reaction chamber has a surface area configured to have a ratio of the surface area of the susceptor to a surface area of an object-to-be-processed in the range of 1.08 to 1.38.

14. The method according to any one of Claims 9-13, wherein the showerhead and a susceptor disposed inside the reaction chamber are configured to have a ratio of a surface area of the showerhead to a surface area of the susceptor in the range of 1.05 to 1.44.

15. A method for self-cleaning a plasma CVD apparatus comprising the steps of:

selecting a susceptor having a ratio of a surface area of the susceptor to a surface area of an object-to-be-processed in the range of 1.08 to 1.38;
selecting a showerhead having a ratio of a surface area of a showerhead to a surface area of the susceptor in the range of 1.05 to 1.44;
processing an object placed on the susceptor, and
initiating self-cleaning by (i) controlling a temperature of the showerhead within the range of $200°C$ to $400°C$; (ii) activating a cleaning gas and placing resultant active cleaning species in a reaction chamber; and (iii) generating a plasma in the reaction chamber, thereby conducting self-cleaning at a designated pressure.

16. The method according to Claim 15, wherein the processing step includes heating the showerhead to a temperature of $200°C$ to $400°C$.

17. The method according to Claim 16, further comprising optimizing self-cleaning frequencies based on a maximum thickness of a film deposited on the showerhead which does not cause particle contamination at a temperature of $200°C$ to $400°C$ and a cleaning speed at a temperature of $200°C$ to $400°C$.

18. The method according to any one of Claims 15-17, wherein the activation of the cleaning gas is conducted in a remote plasma chamber.

# FIG. 1

# FIG. 2

# FIG. 3

# FIG. 4

# FIG. 5.

# FIG. 6